# EUROPEAN PATENT SPECIFICATION

(11) **EP 0 585 769 B1**
(45) Date of publication and mention of the grant of the patent: **07.10.1998**
(21) Application number: 93113443.1
(22) Date of filing: 24.08.1993
(51) Int. Cl.: G01R 31/00

(54) **Portable test equipment for checking the efficiency of an electronic control unit of a system installed in a motor vehicle**
Tragbares Testgerät zur Überprüfung der Leistungsfähigkeit einer elektronischen Steuereinheit eines Motorfahrzeugs
Dispositif de test portatif pour contrôler le rendement d'un unité de réglage dans un véhicule moteur

(30) Priority: 04.09.1992 IT TO920737
(43) Date of publication of application: 09.03.1994
(73) Proprietor: FIAT AUTO S.p.A., 10135 Torino (IT)
(72) Inventor: Di Lago, Vincenzo, I-10040 Rivalta (Torino) (IT); Montani, Emilio, I-10135 Torino (IT); Gallo, Antonino, I-10154 Torino (IT)
(74) Representative: Quinterno, Giuseppe

(56) References cited:
- EP-A- 408 867
- EP-A- 416 171
- WO-A-92/02825
- FR-A- 2 654 519
- ELECTRONIQUE INDUSTRIELLE vol. 6, no. 167, November 1989, PARIS,FR pages 59 - 63 , XP000072687 'contrôle de stations de diagnostic automobile par un testeur économique'

## Description

The subject of the present invention is portable test equipment for checking the efficiency of an electronic control unit of a system installed in a motor vehicle, in which the unit is connected to devices of the system by means of a plurality of wired communication and/or control lines, the unit being arranged to run programmes for automatically diagnosing operating anomalies or breakdowns in the system to which it belongs and to supply corresponding signals at its diagnosis outputs, the test equipment comprising an anomaly- or breakdown-simulator including:
- a plurality of connecting lines for establishing the continuity of the connections between the control unit and the devices of the system when the breakdown simulator is interposed between them, each connecting line being associated with respective electrical or electronic switch means,
- an interrogation/acquisition device, and
- a microprocessor control terminal which is connected to the anomaly- or breakdown-simulator and to the interrogation/acquisition device and includes control means, and a microprocessor control and operating unit for generating driving signals and for acquiring and storing the diagnostic data obtained by means of the interrogation/acquisition device.

The use of on-board electronic control systems in motor vehicles for controlling one or more functions of the engine or of the motor vehicle in general, for example, the ignition and the fuel injection, the antilock braking, active control of the suspension, etc. is now widespread.

Various types of test equipment for checking the efficiency of the electronic control unit or units of these systems have correspondingly been proposed.

International Patent Application WO-A-92/02825 discloses a test equipment of the above-mentioned type, in which the connecting lines extend in a connector of "T" configuration which is interposed between a connector of the electronic unit of the vehicle and a connector coupled to the various devices of the system. Electronic switches are included in an autotest or manual breakout box to connect the pins of the "T" connector with a microprocessor terminal. The microprocessor interprets any fault signals on the basis of measured parameters on the connecting lines rather than simulation of anomaly or breakdown. Further, certain measurements cannot be performed by means of the test equipment and require use of external apparatuses.

The object of the present invention is to provide portable test equipment which, in particular, can be carried on board a motor vehicle and enables extremely flexible, reliable and complete diagnostic checking of the functions of a control unit of such an on-board system.

According to the invention, this object is achieved by means of the above-defined equipment characterised in that the electrical or electronic switch means, comprise
- first, second and third normally-closed electrical or electronic switches connected in series and interposed in each connecting line of the simulator,
- the first and second switches being arranged to connect the associated line to a supply voltage and to an earth conductor respectively when they receive respective control signals, and the third switch being arranged to break the associated line when it in turn receives a control signal.

Further characteristics and advantages of the equipment according to the invention will became clear from the detailed description which follows with reference to the appended drawings, provided purely by way of non-limiting example, in which:
Figure 1 is a block diagram of a system for controlling one or more functions of a motor vehicle according to a prior art,
Figure 2 is a block diagram showing test equipment according to the invention applied to the system shown schematically in Figure 1, and
Figure 3 is a circuit diagram, partially in block form, of an anomaly- or breakdown-simulator included in the equipment according to the invention.

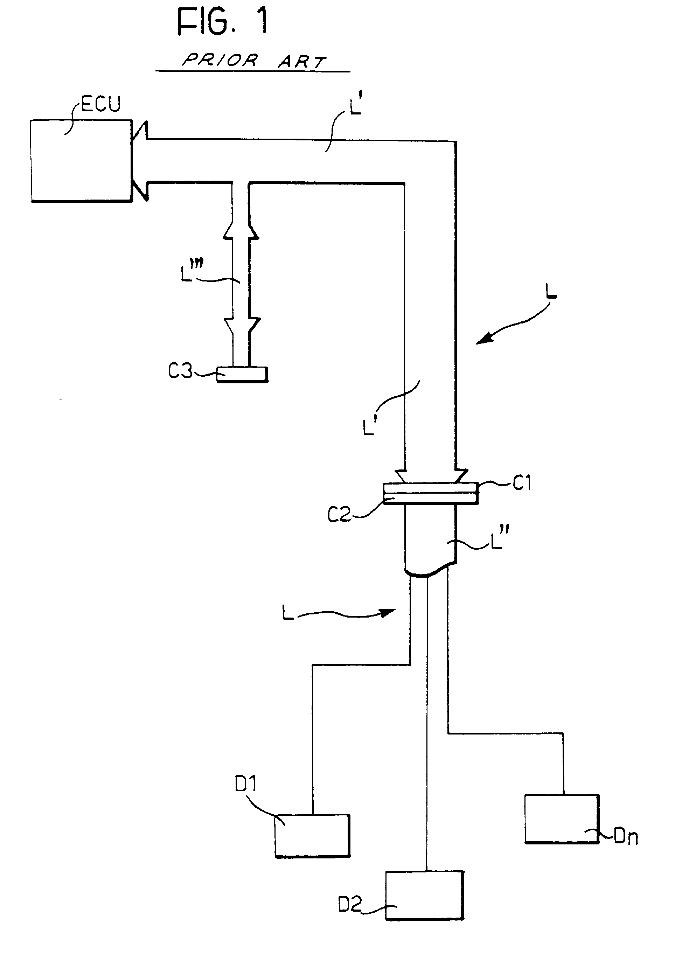

With reference to Figure 1, a system for controlling one or more functions of a motor vehicle includes, in known manner, an electronic control unit ECU which is typically formed with the use of a microprocessor, and is connected to devices D1, D2 ... Dn of the system by means of a set L of wired communication and/or control lines.

The devices D1 ... Dn may be constituted by sensors, actuators, etc.

According to current practice, the set of lines L which connect the unit ECU to the devices D1 ... Dn is divided into a multicore cable L' which connects the terminals of the unit ECU to a connector C1, and a second cable L'' one end of which is connected to a connector C2 which can be connected to and disconnected from the connector C1. The multicore cable L'' branches into a plurality of wires or lines which reach the various devices D1, D2 ... Dn of the system.

In many electronic control systems installed in motor vehicles, the unit ECU is arranged to run programmes for diagnosing operating anomalies or breakdowns of the devices D1 ... Dn of the system to which it belongs and to provide corresponding diagnostic signals at its outputs which are known as diagnosis outputs.

The diagnosis outputs of the unit ECU of such a system are often connected to respective wires or lines which extend within the cable indicated L' in Figure 1 and correspondingly reach the connector C1. Further wires or lines, generally indicated L''', often branch off these wires or lines and terminate in a connector, known as the diagnosis connector, which is indicated C3 in Figure 1.

According to the ISO standard, on-board control units ECU have three diagnosis outputs connected to corresponding diagnosis wires. Thus, according to this standard, the connector C3 is tripolar.

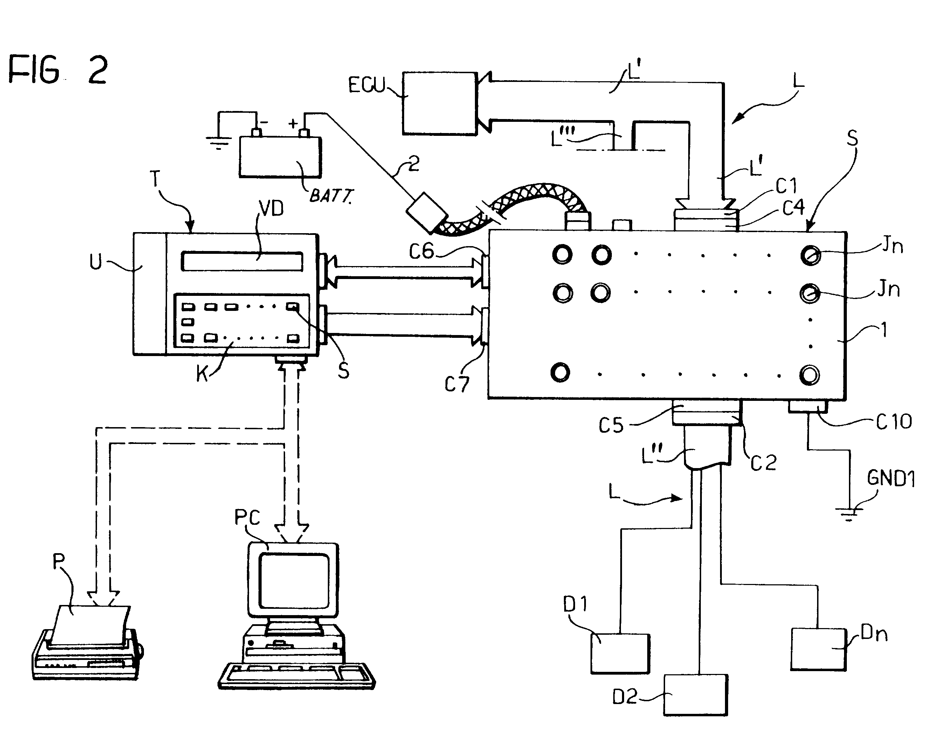

With reference to Figure 2, portable test equipment for checking the efficiency of an electronic control unit ECU includes essentially a portable microprocessor control terminal T and an anomaly- or breakdown-simulator indicated S.

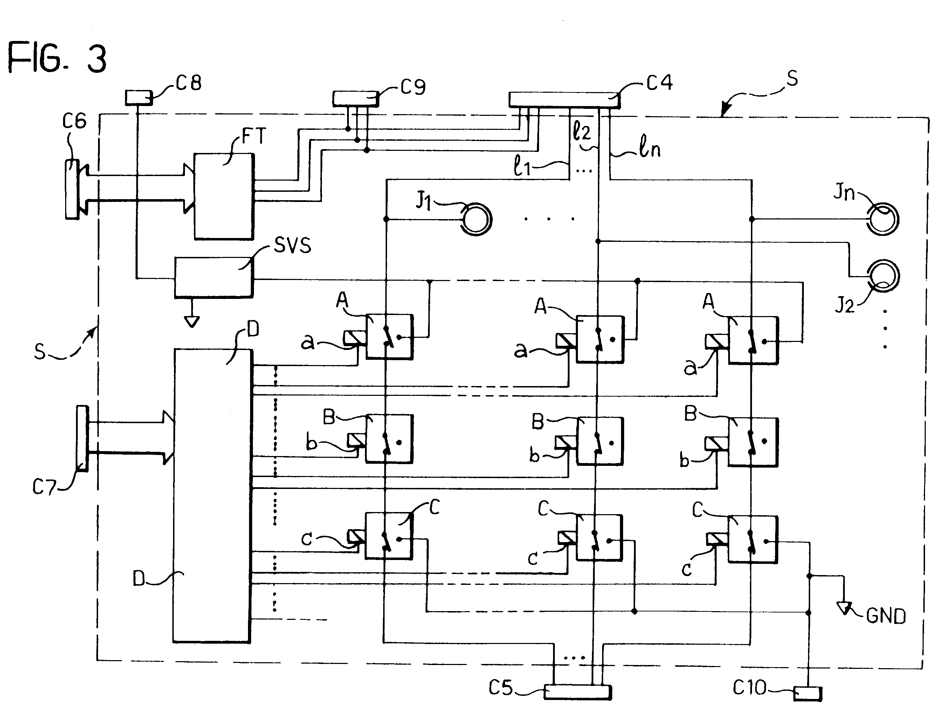

In the embodiment shown by way of example in Figures 2 and 3, the breakdown simulator includes a closed casing l with two main connectors C4 and C5 for connection to the connector C1 and the connector C2, respectively, of the wiring which interconnects the unit ECU and the devices D1 ... Dn.

The anomaly- or breakdown-simulator S has further connectors indicated C6 and C7 for connection to the portable control terminal T.

Further connectors C8, C9 and C10 of the simulator S serve for purposes which will be described further below.

As can be seen from Figure 3, a plurality of connecting lines l1, l2 ... ln extends within the anomaly- or breakdown-simulator S between the connectors C4 and C5 to establish the continuity of the connections between the control unit ECU and the devices D1, D2 ... Dn of a system under test when the simulator S is interposed between them.

Three normally-closed electrical or electronic switches, indicated A, B and C, are interposed in each connecting line l1, l2 ... ln. The switches are connected in series and, conveniently, are constituted by relays.

The respective control inputs a, b and c of the switches A, B and C are connected in an orderly manner to corresponding outputs of a decoding circuit D, the inputs of which are connected to the connector C7. In operation, the decoding circuit D receives coded signals from the control terminal T by means of this connector; the coded signals can selectively cause one or more of the switches A, B and C of one or more predetermined lines l1, l2 ... ln to switch.

When a control signal reaches the input a of a switch A, the switch breaks the associated connecting line 1 and connects the upper portion of that line (that is, the portion between the switch A and the connector C4) to the output of a stabilised supply SVS, the input of which is connected to the connector C8. This latter connector is connected, in use, to the positive pole of the motor-vehicle battery, indicated BATT in Figure 2, by means of a cable indicated 2 in the same drawing.

When a control signal reaches the control input b of a switch B through the decoder D, the switch breaks the electrical continuity of the connecting line 1 in which it is disposed.

When a control signal reaches the input c of a switch C, however, this switch connects the upstream portion of the connecting line to which it belongs to an earth conductor GND within the breakdown-simulator S.

The earth conductor GND is connected to the connector C10, as can be seen in Figure 3.

When the anomaly- or breakdown-simulator S is interposed between the electronic control unit ECU under test and the devices D1, D2 ... Dn, the selective control of the switches A, B and C enables any type of anomaly or breakdown which may actually occur in the system to which the unit ECU and the devices D1, D2 ... Dn belong to be simulated. In fact, these anomalies or breakdowns can generally be attributed to a short-circuit to the voltage supply, a broken connection, or a lack of signals from one of the devices D1, D2 ... Dn, or a short-circuit to earth.

In use, an external earth conductor (a local earth), indicated GND1 in Figure 2, that is, the earth conductor to which one or more devices D1, D2 ... Dn of the system are actually connected, can be connected to the connector C10 of the simulator S.

As shown in Figure 3, each connecting line 11, 12 ... ln of the simulator S is connected to a respective connector J1, J2 ... Jn which is accessible from outside for the connection of measuring instruments or external signal-generators.

The connectors J1, J2 ... Jn are connected to the connecting lines l1, l2 ... ln upstream of the associated switches A, B, C.

The anomaly- or breakdown-simulator S also includes a device, indicated FT in Figure 3, for acquiring the diagnostic data. This device can be connected to the diagnosis outputs of the control unit ECU by means of the connector C9 and/or by means of the connector C4. In operation, it is also connected to the control terminal T by the connector C6, by means of a bidirectional bus.

The device FT for acquiring diagnostic data is constituted, for example, by the devices typically included in the test equipment marketed by the Applicant under the name FIAT TESTER.

As can be seen in Figure 2, the control terminal T includes a control keypad K and a display device VD constituted, for example, by an alpha-numeric or graphic display.

The terminal includes a microprocessor unit equipped with nonvolatile memory means.

In use, the user can programme, by means of the keypad K, the type, number, duration, sequence and, possibly, the frequency of repetition of the anomalies or breakdowns to be simulated and the diagnostic data to be acquired.

Once the parameters of the breakdown simulation and the diagnostic data to be acquired have been programmed, the operator can start the simulation by means of a suitable control push-button S on the keypad K.

According to the type of on-board system to be checked and the type of breakdown simulation to be carried out, it may be necessary to bring the vehicle to a predetermined operating condition beforehand. Thus, for example, in order to check the efficiency of an antilock braking system (ABS), it is necessary to set the motor vehicle in motion beforehand and then to operate the brakes.

Anyway, once the simulation has been started by means of the control push-botton S of the terminal T, the microprocessor control unit of the terminal sends the decoder D of the simulator S coded signals to activate the switches A and/or B and/or C selectively in order to simulate the anomalies or breakdowns in the manner programmed beforehand by the operator by means of the keypad K.

During the test, the device FT of the simulator S acquires the diagnostic signals emitted by the control unit ECU of the system under test.

The control terminal T in turn acquires from the device FT the diagnostic data which the operator previously selected with the keypad K before the test started, and stores the data. The diagnostic data then remain stored in the control terminal T even after the test has been carried out.

In order to restrict the size of the terminal T as much as possible, its internal nonvolatile memory devices are conveniently of a size such that they can hold the diagnostic data which can be acquired in a predetermined limited number of tests.

The terminal T may conveniently be connected to a copying unit, indicated U in Figure 2, for copying the diagnostic data acquired by the terminal onto external portable magnetic memory substrates, such as so-called memory cards.

The terminal T may also be equipped with serial communication interfaces, for example, according to the RS232 standard, so that it can be connected to an external processor, such as the personal computer indicated PC in Figure 2, or to a printer, indicated P in the same drawing.

The control unit within the control terminal T may be arranged, by means of suitable software, to enable the terminal to be used by means of guide menus, in order to facilitate both the programming of the types, durations, and the other parameters of the anomalies or breakdowns to be simulated and the selection of the diagnosis data to be acquired.

Naturally, the principle of the invention remaining the same, the forms of embodiment and details of construction may be varied widely with respect to those described and illustrated purely by way of non-limiting example, without thereby departing from the scope of the present invention as defined in the annexed claims.

## Claims

1. Portable test equipment for checking the efficiency of an electronic control unit (ECU) of a system installed in a motor vehicle, in which the unit (ECU) is connected to devices (D1, D2 ...Dn) of the system by means of a plurality of wired communication and/or control lines (L, L', L''), the unit (ECU) being arranged to run programmes for diagnosing operating anomalies or breakdowns in the system to which it belongs and to supply corresponding signals at its diagnosis outputs,
the test equipment comprising an anomaly- or breakdown-simulator (S), including:
- a plurality of connecting lines (l1, l2 ... ln) for establishing the continuity of the connections between the control unit (ECU) and the devices (D1, D2 ...Dn) of the system when the breakdown simulator (S) is interposed between them, each connecting line (l1, l2, ... ln) being associated with respective electrical or electronic switch means (A, B, C),
- an interrogation/acquisition device (FT), and
- a microprocessor control terminal (T) which is connected to the anomaly- or breakdown-simulator (S) and to the interrogation/acquisition device (FT) and includes control means (K, S), and a microprocessor control and operating unit for generating driving signals and for acquiring and storing the diagnostic data obtained by means of the interrogation/acquisition device (FT),
the said test equipment being characterised in that the electrical or electronic switch means (A, B, C), comprise first, second and third normally-closed electrical or electronic switches (A, C, B) connected in series and interposed in each connecting line (l1, l2 ... ln) of the simulator (S),
- the first, and second switches (A, C) being arranged to connect the associated line (l1, l2 ... ln) to a supply voltage (SVS) and to an earth conductor (GND; GND1) respectively when they receive respective control signals, and the third switch (B) being arranged to break the associated line (l1, l2 ... ln) when it in turn receives a control signal.

2. Equipment according to Claim 1, characterised in that the anomaly- or breakdown-simulator (S) includes a decoding circuit (D) the inputs of which are connected to the control unit of the control terminal (T) in order to receive coded address and control signals for the selective activation of the electrical or electronic switches (A, B, C) associated with the connecting lines (11, 12 ...ln), and the outputs of which are connected in an orderly manner to the driving inputs of the electric or electronic switches (A, B, C).

3. Equipment according to Claim 2, characterised in that the anomaly- or breakdown-simulator (S) includes a stabilised voltage supply (SVS) having an input for being connected to the battery (BATT) of the motor vehicle, and an output connected to the first electrical or electronic switches (A).

4. Equipment according to any one of the preceding claims, characterised in that the electrical or electronic switches (A, B, C) of the simulator (S) are constituted by relays.

5. Equipment according to any one of the preceding claims, characterised in that the simulator (S) has a terminal (C10) which is connected to the second switches (C) associated with the connection lines (l1, l2, ... ln) and for being connected to an external earth conductor (GND1).

6. Equipment according to any one of the preceding claims, characterised in that each connecting line (l1, l2 ...ln) of the simulator (S) is connected to a respective connector (J1, J2 ... Jn) which is accessible from outside to enable measuring instruments or electrical-signal generators to be connected to the respective line.

7. Equipment according to any one of the preceding claims, characterised in that the control means of the control terminal (T) comprise a keypad (K, S) for manual programming the type, number, duration, sequence and the frequency of the anomalies or breakdowns to be simulated and the diagnostic data to be acquired.

8. Equipment according to any one of the preceding claims, characterised in that the control terminal (T) includes an alpha-numeric or graphic display (VD).

9. Equipment according to any one of the preceding claims, characterised in that the control terminal (T) is associated with a unit (U) for copying the acquired diagnostic data in the internal memory means of the terminal (T) onto external portable memory substrates.

10. Equipment according to any one of the preceding claims, characterised in that it comprises a connector (C9) for being connected to the diagnosis outputs (L''') of the control unit (ECU).

## Patentansprüche

1. Tragbares Prüfgerät, um die Leistungsfähigkeit einer elektronischen Steuereinheit (ECU) eines Systems zu überprüfen, das in ein Kraftfahrzeug eingebaut ist, wobei die Einheit (ECU) mit Einrichtungen (D1, D2 ... Dn) des Systems über eine Vielzahl von verdrahteten Kommunikations- und/oder Steuerleitungen (L, L', L'') verbunden ist, wobei die Einheit (ECU) so aufgebaut ist, daß sie Programme fährt, um Unregelmäßigkeiten im Betrieb oder Betriebsstörungen in jenem System zu diagnostizieren, dem die Einheit zugeordnet ist, und an ihre Diagnoseausgänge entsprechende Signale zu legen,
wobei das Prüfgerät einen Simulator für Unregelmäßigkeiten und Betriebsstörungen (S) enthält, der aufweist:
- eine Vielzahl von Verbindungsleitungen (l1, l2 ... ln), um die Verbindungen zwischen der Steuereinheit (ECU) und den Einrichtungen (D1, D2 ... Dn) des Systems weiterhin aufrechtzuerhalten, wenn der Simulator für die Betriebsstörungen (S) dazwischengeschaltet wird, wobei jeder Verbindungsleitung (l1, l2 ... ln) eine entsprechende elektrische oder elektronische Schaltereinrichtung (A, B, C) zugeordnet ist,
- eine Abfrage/Datenerfassungs-Einrichtung (FT), und
- ein Mikroprozessor-Steuerendgerät (T), das mit dem Simulator für Unregelmäßigkeiten und Betriebsstörungen (S) sowie mit der Abfrage/Datenerfassungs-Einrichtung (FT) verbunden ist und eine Steuereinrichtung (K, S) aufweist, sowie eine Mikroprozessor-Steuer- und Betriebseinheit, um Ansteuersignale zu erzeugen und jene Diagnosedaten zu erfassen und zu speichern, die man mit Hilfe der Abfrage/Datenerfassungs-Einrichtung (FT) erhält,
wobei das Prüfgerät dadurch gekennzeichnet ist, daß die elektrische oder elektronische Schaltereinrichtung (A, B, C) enthält:
- einen ersten, zweiten und dritten normalerweise geschlossenen elektrischen oder elektronischen Schalter (A, C B,), die in Serie geschaltet sind und in jeder Verbindungsleitung (l1, l2 ... ln) des Simulators (S) liegen,
- wobei der erste und zweite Schalter (A, C) so angeordnet sind, um die zugeordnete Leitung (l1, l2 ... ln) mit einer Versorgungsspannung (SVS) bzw. mit einem Masseleiter (GND; GND1) zu verbinden, wenn sie entsprechende Steuersignale empfangen, und wobei der dritte Schalter (B) so angeordnet ist, um die zugeordnete Leitung (l1, l2 ... ln) zu unterbrechen, wenn er seinerseits ein Steuersignal empfängt.

2. Gerät gemäß Anspruch 1, dadurch gekennzeichnet, daß der Simulator für Unregelmäßigkeiten und Betriebsstörungen (S) eine Dekoderstufe (D) aufweist, deren Eingänge mit der Steuerstufe des Steuerendgeräts (T) verbunden sind, um kodierte Adressensignale und Steuersignale für die wahlweise Betätigung der elektrischen oder elektronischen Schalter (A, B, C) zu empfangen, die den Verbindungsleitungen (l1, l2 ... ln) zugeordnet sind, und deren Ausgänge planmäßig an den Ansteuereingängen der elektrischen oder elektronischen Schalter (A, B, C) liegen.

3. Gerät gemäß Anspruch 2, dadurch gekennzeichnet, daß der Simulator für Unregelmäßigkeiten und Betriebsstörungen (S) eine stabilisierte Spannungsversorgung (SVS) aufweist, die einen Eingang besitzt, der mit der Batterie (BATT) des Kraftfahrzeugs verbunden werden kann, sowie einen Ausgang besitzt, der mit dem ersten elektrischen oder elektronischen Schalter (A) verbunden werden kann.

4. Gerät gemäß irgendeinem der bisherigen Ansprüche, dadurch gekennzeichnet, daß die elektrischen oder elektronischen Schalter (A, B, C) des Simulators (S) von Relais gebildet werden.

5. Gerät gemäß irgendeinem der bisherigen Ansprüche, dadurch gekennzeichnet, daß der Simulator (S) einen Anschluß (C10) besitzt, der mit den zweiten Schaltern (C) verbunden ist, die den Verbindungsleitungen (l1, l2 ... ln) zugeordnet sind, wobei er mit einem externen Masseleiter (GND1) verbunden werden kann.

6. Gerät gemäß irgendeinem der bisherigen Ansprüche, dadurch gekennzeichnet, daß jede Verbindungsleitung (l1, l2 ... ln) des Simulators (S) mit einem entsprechenden Stecker (J1, J2 ... Jn) verbunden ist, der von außen zugänglich ist, um Meßinstrumente oder elektrische Signalgeneratoren mit der entsprechenden Leitung verbinden zu können.

7. Gerät gemäß irgendeinem der bisherigen Ansprüche, dadurch gekennzeichnet, daß die Steuereinrichtung des Steuerendgeräts (T) eine Tastatur (K, S) besitzt, um mit der Hand die Art, die Anzahl, die Dauer, die Reihenfolge und die Frequenz von Unregelmäßigkeiten oder Betriebsstörungen, die simuliert werden sollen, sowie die Diagnosedaten zu programmieren, die erfaßt werden sollen.

8. Gerät gemäß irgendeinem der bisherigen Ansprüche, dadurch gekennzeichnet, daß das Steuerendgerät (T) eine alphanumerische oder graphische Anzeige (VD) aufweist.

9. Gerät gemäß irgendeinem der bisherigen Ansprüche, dadurch gekennzeichnet, daß dem Steuerendgerät (T) eine Einheit (U) zugeordnet ist, um die erfaßten Diagnosedaten im internen Speicher des Endgeräts (T) auf externe, tragbare Speichermedien zu kopieren.

10. Gerät gemäß irgendeinem der bisherigen Ansprüche, dadurch gekennzeichnet, daß das Gerät einen Stecker (C9) enthält, der mit den Diagnoseausgängen (L''') der Steuereinheit (ECU) verbunden werden kann.

## Revendications

1. Appareil portatif d'essais destiné à vérifier l'efficacité d'une unité électronique de commande (ECU) d'un système installé dans un véhicule à moteur, dans lequel l'unité (ECU) est connectée à des dispositifs (D1, D2,... Dn) du système par plusieurs lignes câblées de communications et/ou de commande (L, L', L"), l'unité (ECU) étant disposée afin qu'elle exécute des programmes de diagnostic des anomalies ou pannes de fonctionnement dans le système auquel elle appartient et à transmettre des signaux correspondants à ses sorties de diagnostic,
l'appareil d'essais comprenant un simulateur (S) d'anomalies ou de pannes qui comprend:
- plusieurs lignes de connexion (l1, l2,... ln) destinées à établir la continuité des connexions entre l'unité de commande (ECU) et les dispositifs (D1, D2,... Dn) du système lorsque le simulateur (S) de pannes est placé entre eux, chaque ligne de connexion (l1, l2,... ln) étant associée à un dispositif respectif de commutation électrique ou électronique (A, B, C),
- un dispositif d'interrogation-acquisition (FT), et
- un terminal de commande (T) à microprocesseur qui est connecté au simulateur (S) d'anomalies ou de pannes et au dispositif (FT) d'interrogation-acquisition et qui comprend un dispositif de commande (K, S) et une unité de commande et d'exploitation de microprocesseur destinée à créer des signaux de pilotage et pour l'acquisition et la mémorisation de données de diagnostic obtenues à l'aide du dispositif d'interrogation-acquisition (FT),
l'appareil d'essais étant caractérisé en ce que le dispositif à commutateur électrique ou électronique (A, B, C) comporte un premier, un second, et un troisième commutateur électrique ou électronique normalement fermé (A, C, B) connectés en série et disposés dans chaque ligne de connexion (11, l2,... ln) du simulateur (S),
- le premier et le second commutateur (A, C) étant destinés à connecter la ligne associée (l1, l2,... ln) à une tension d'alimentation (SVS) et à un conducteur de masse (GND ; GND1) respectivement lorsqu'ils reçoivent des signaux respectifs de commande, et le troisième commutateur (B) étant destiné à ouvrir la ligne associée (l1, l2,... ln) lorsqu'il reçoit à son tour un signal de commande.

2. Appareil selon la revendication 1, caractérisé en ce que le simulateur d'anomalies ou de pannes (S) comporte un circuit de décodage (D) dont les entrées sont connectées à l'unité de commande du terminal de commande(T) pour la réception de signaux codés d'adresse et de commande assurant l'activation sélective des commutateurs électriques ou électroniques (A, B, C) associés aux lignes de connexion (l1, l2,... ln), et dont les signaux de sortie sont connectés de manière ordonnée aux entrées de pilotage des commutateurs électriques ou électroniques (A, B, C).

3. Appareil selon la revendication 2, caractérisé en ce que le simulateur (S) d'anomalies ou de pannes comprend une alimentation stabilisée (SVS) ayant une entrée destinée à être connectée à la batterie (BATT) du véhicule à moteur, et une sortie connectée aux premiers commutateurs électriques ou électroniques (A).

4. Appareil selon l'une quelconque des revendications précédentes, caractérisé en ce que les commutateurs électriques ou électroniques (A, B, C) du simulateur (S) sont constitués par des relais.

5. Appareil selon l'une quelconque des revendications précédentes, caractérisé en ce que le simulateur (S) a une borne (C10) qui est connectée aux seconds commutateurs (C) associés aux lignes de connexion (l1, l2,... ln) et destinée à être connectée à conducteur externe de masse (GND1).

6. Appareil selon l'une quelconque des revendications précédentes, caractérisé en ce que chaque ligne de connexion (l1, l2,... ln) du simulateur (S) est connectée à un connecteur respectif (J1, J2,... Jn) qui est accessible depuis l'extérieur afin qu'il permette la connexion à la ligne respective d'instruments de mesure ou de générateurs de signaux électriques.

7. Appareil selon l'une quelconque des revendications précédentes, caractérisé en ce que le dispositif de commande du terminal de commande (T) comporte un pavé de touches (K, S) de programmation manuelle du type, du nombre, de la durée, de la séquence et de la fréquence des anomalies ou pannes à simuler et des données de diagnostic à obtenir.

8. Appareil selon l'une quelconque des revendications précédentes, caractérisé en ce que le terminal de commande (T) comprend un dispositif d'affichage alphanumérique ou graphique (VD).

9. Appareil selon l'une quelconque des revendications précédentes, caractérisé en ce que le terminal de commande (T) est associé à une unité (U) de copie des données de diagnostic obtenues dans la mémoire interne du terminal (T) sur des substrats portatifs extérieurs de mémoire.

10. Appareil selon l'une quelconque des revendications précédentes, caractérisé en ce qu'il comprend un connecteur (C9) destiné à être connecté aux sorties de diagnostic (L"') de l'unité de commande (ECU).
